# FASCICULE DE BREVET EUROPEEN

(11) **EP 3 479 193 B1**
(45) Date de publication et mention de la délivrance du brevet: **11.03.2020**
(21) Numéro de dépôt: 17742821.6
(22) Date de dépôt: 29.06.2017
(51) Int. Cl.: G06F 1/18, H05K 5/02, H05K 7/14

(54) **SYSTÈME DE RÉPARTITION DE CHARGE AU SOL POUR ARMOIRE INFORMATIQUE**
BODENLASTVERTEILENDES SYSTEM FÜR RECHNERSCHRANK
FLOOR LOAD-SPREADING SYSTEM FOR COMPUTER CABINET

(30) Priorité: 01.07.2016 FR 1656322
(43) Date de publication de la demande: 08.05.2019
(73) Titulaire: Bull SAS, 78340 Les Clayes-sous-Bois (FR)
(72) Inventeur: DEMANGE, Fabien, 78300 Poissy (FR); DALLASERRA, Luc, 75009 Paris (FR)
(74) Mandataire: Cabinet Camus Lebkiri
(86) Numéro de dépôt international: PCT/FR2017/051743
(87) Numéro de publication internationale: WO 2018/002532

(56) Documents cités:
- EP-A1- 1 701 602
- US-A1- 2008 218 948

## Description

### DOMAINE TECHNIQUE DE L'INVENTION

La présente invention a pour objet un Système de répartition de charge au sol pour armoire informatique.

La présente invention concerne un système mécanique permettant d'optimiser la répartition de charge au sol des armoires informatiques et ainsi de réduire les contraintes locales s'appliquant sur des faux-planchers dans les centres de données. Un centre de données est aussi appelé une ferme de serveurs ou un « datacenter ».

### ETAT DE LA TECHNIQUE ANTERIEURE

Une ferme de serveur est classiquement une salle dans laquelle sont installées une pluralité d'armoires informatiques. Ces armoires sont organisées en rangées, chaque rangée étant composée d'armoires jointives. Une telle salle comporte un faux plancher sur lequel les armoires sont posées. Des câbles ou tuyaux sortent par les planchers des armoires et circulent sous le faux plancher de la salle.

Pour leur mise en place les armoires sont déplacées en les faisant rouler. La face externe du plancher d'une armoire intégrant quatre roulettes périphériques.

Une fois une armoire informatique positionnée dans la salle, un système classique de liaison au sol est réalisé avec des vérins situés sous l'armoire assurant la stabilisation ainsi que la transmission des efforts vers le faux-plancher. Un tel vérin est, classiquement, une tige filetée introduite dans un taraudage du plancher de l'armoire et comportant à son extrémité une calle.

Ce système classiquement utilisé jusqu'à présent consiste donc à placer des vérins rétractables sous l'armoire informatique. Ces vérins sont dans les quatre coins au minimum et parfois plus en fonction de la charge à supporter.

Une fois amenée sur ses roulettes à l'emplacement final, les vérins de l'armoire sont descendus manuellement un à un pour venir en contact avec le sol jusqu'à décoller à peine les roulettes du sol. L'armoire est alors stable.

Ce système classique présente plusieurs limitations, en particulier quand le poids des armoires augmente au-delà de 1500kg. En effet :
- Le poids de l'armoire informatique est transmis au faux plancher par les vérins représentant donc de très faibles surfaces de liaisons au sol. Cela pose des problèmes de poinçonnage des dalles du faux-plancher lorsque le poids de l'armoire informatique augmente et nécessite d'augmenter très fortement la résistance des dalles dans les datacenters.
- La classe de faux plancher ne peut pas être indéfiniment augmentée pour résister à davantage d'efforts ce qui pourrait être disqualifiant pour des bâtiments pour des systèmes modernes comportant des armoires informatiques lourdes.
- Lorsque les armoires ont des largeurs différentes de celles des dalles du faux-plancher (600mm étant le plus courant), les vérins localisés dans les coins des armoires ne se trouvent plus dans les coins des dalles. Les coins des dalles étant les endroits soutenus par les piliers de la structure des faux-plancher et donc les plus susceptibles de supporter la charge, le fait d'avoir des armoires informatiques de largeur différentes déplace les concentrations de contraintes dans le faux-plancher en dehors des zones les plus rigides et résistante, ce qui devient un réel problème.
- Le fait d'augmenter le nombre de vérins sous l'armoire est difficile voire impossible pour des questions d'accessibilité. Etant donné que les armoires viennent se coller les unes aux autres dans les rangées de datacenters, seuls les faces avant et arrièred'un rack déjà en place sont accessibles ce qui limite les placements possibles pour les vérins. Ce problème est encore accentué si l'on souhaite garder la possibilité de retirer une armoire indépendamment des autres de la rangée. Des dispositifs de répartition de charge au sol pour une armoire informatique comportant un plancher dont une face externe est destinée à être positionnée face au sol sont décrits dans EP 1701602 A1 et US 2008/218948 A1.

### EXPOSE DE L'INVENTION

Le principe de l'invention consiste à créer une structure mécanique amovible se plaçant entre le plancher de l'armoire et le sol. Cette structure, dans une variante préféré en forme de 8, est réalisée avec des poutres permettant d'augmenter la surface de transmission d'efforts au sol tout en s'approchant plus facilement des zones les plus rigides du faux plancher qu'avec un système de vérins classique.
Le système de répartition de charge est donc, dans une variante, un système constitué de 5 poutres, dont la section peut varier en fonction du poids de l'armoire informatique, qui vont s'assembler directement dans la salle d'installation de l'armoire. Une procédure d'installation dans la variante à 5 poutres consiste à soulever l'armoire à l'aide d'un outil de levage et de glisser dans un ordre prédéfini les différentes poutres sous l'armoire et enfin de les solidariser entre elles par des vis.
Les poutres sont, par exemple, réalisées via un profilé d'extrusion en aluminium et possèdent une structure en croisillon garantissant sa résistance mécanique sous le poids de l'armoire. Les poutres comportent une fente sur le dessus du profilé. Celle-ci permet de venir glisser les poutres dans des pions sertis dans le fond de l'armoire informatique et ainsi de les lier à la structure de l'armoire. Cela facilite le montage ainsi que la transmission répartie des efforts entre la structure de l'armoire informatique et le système de répartition de charge.
Le système selon l'invention est compatible avec les positions des roulettes placées sous l'armoire ainsi qu'avec les sorties de câbles ou de tuyaux vers la zone technique du faux-plancher de la salle d'installation de l'armoire.
Outre les avantages de surface de contact augmentée, le système selon l'invention permet aussi de mieux moyenner les efforts vus par les différentes zones rigides du faux-plancher (pieds de renfort) en exploitant notamment les pieds centraux sous les armoires qui sont moinssollicités dans le cas d'armoire avec vérins.

Dans ce dessein, un aspect de l'invention se rapporte à un dispositif de répartition de charge au sol pour une armoire informatique comportant un plancher dont une face externe est destinée à être positionnée face au sol caractérisé en ce que :
- la face externe du plancher de l'armoire comporte une pluralité de pions chaque pion comportant à son extrémité la plus éloignée du plancher une tête dont le diamètre est supérieur au diamètre d'une tige du pion, ladite tige et la tête assurant la liaison entre l'armoire et le pion,
- le dispositif de répartition de charge comporte au moins deux poutres, chaque poutre comportant au moins deux faces planes parallèles :
   ∘ une première face comporte une fente servant de rail, la largeur de la fente étant supérieur au diamètre d'une tige de pion mais inférieure au diamètre d'une tête de pion, cette fente coopérant avec au moins deux pions pour la mise en place de la poutre,
   ∘ une deuxième face est en contact avec le sol,
- une fois les poutres en place le poids de l'armoire est réparti sur les deuxièmes surfaces des poutres.

Outre les caractéristiques principales qui viennent d'être mentionnées dans le paragraphe précédent, le dispositif selon l'invention peut présenter une ou plusieurs caractéristiques complémentaires parmi les suivantes, considérées individuellement ou selon les combinaisons techniquement possibles:
- la structure interne d'une poutre est un croisillon ;
- pour la rigidification du dispositif :
   - une première poutre comporte, intégré à sa structure interne, et à l'une des extrémités de la poutre un taraudage,
   - une deuxième poutre comporte, sur les faces autres que celles en contact avec le sol ou l'armoire, un orifice traversant pour le passage d'une vis d'assemblage permettant la solidarisation des première et deuxième poutres, la vis d'assemblage étant vissé dans le taraudage ;
- l'orifice traversant est oblong dans une direction correspondant à la plus grande dimension de la poutre ;
- la hauteur d'une poutre est telle qu'une fois la poutre en place, des roulettes de l'armoire ne sont plus en contact avec le sol ;
- le dispositif comporte cinq poutres:
   - quatre d'entre elles formant un parallélépipède rectangle correspondant au périmètre du plancher de l'armoire,
   - la cinquième joignant deux bords parallèles du parallélépipède,
   - des vis d'assemblages solidarisant les poutres formant le parallélépipède étant introduites via les faces des poutres correspondant aux faces avant et arrière de l'armoire.

### BREVE DESCRIPTION DES FIGURES

D'autres caractéristiques et avantages de l'invention ressortiront à la lecture de la description qui suit, en référence aux figures annexées, qui illustrent :

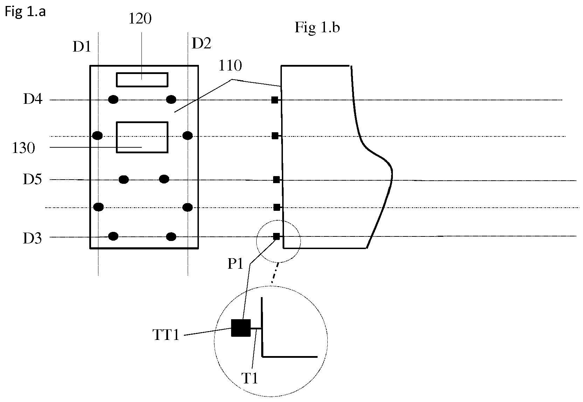

- La figure 1.a: une vue de dessous d'une armoire selon l'invention, la figure n'est pas à l'échelle ;
- La figure 1.b : une vue latérale d'une armoire selon l'invention, la figure n'est pas à l'échelle ;
- La figure 2.a : une vue en coupe transversale d'une poutre utilisée dans un dispositif de répartition de charge selon l'invention ;

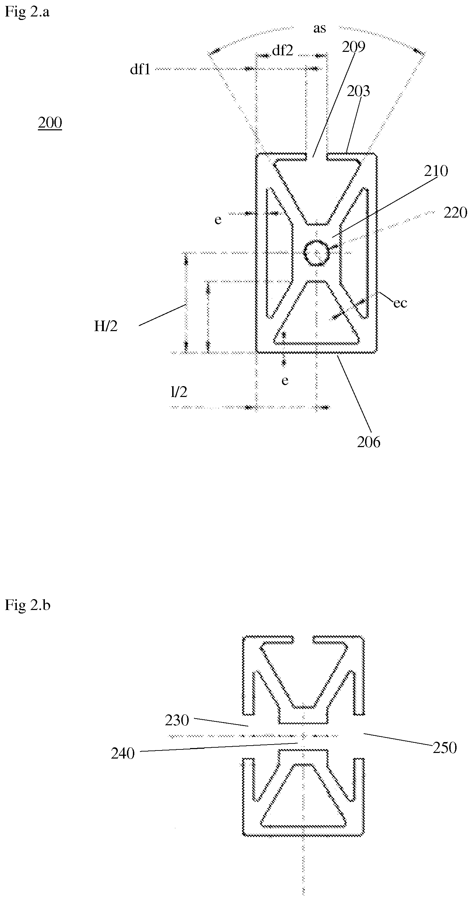

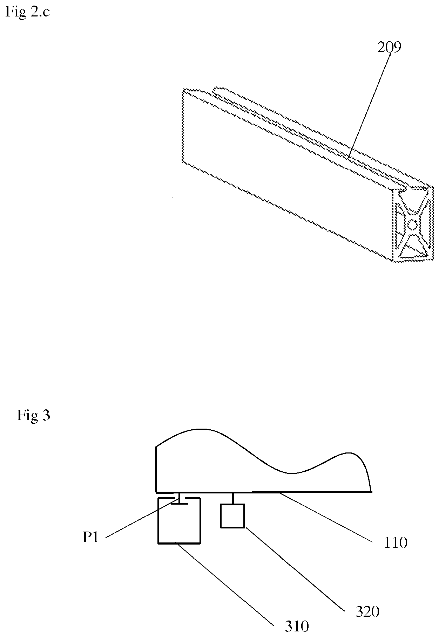

- La figure 2.b : une vue en coupe transversale d'une poutre utilisée dans un dispositif de répartition de charge selon l'invention, la coupe étant réalisée au niveau d'un orifice latérale de la poutre ;
- La figure 2.c : une vue en perspective d'une poutre utilisée dans un dispositif de répartition de charge selon l'invention ;
- La figure 3 : un schéma de détail de l'interaction de l'invention et de moyen de déplacement de l'armoire ;

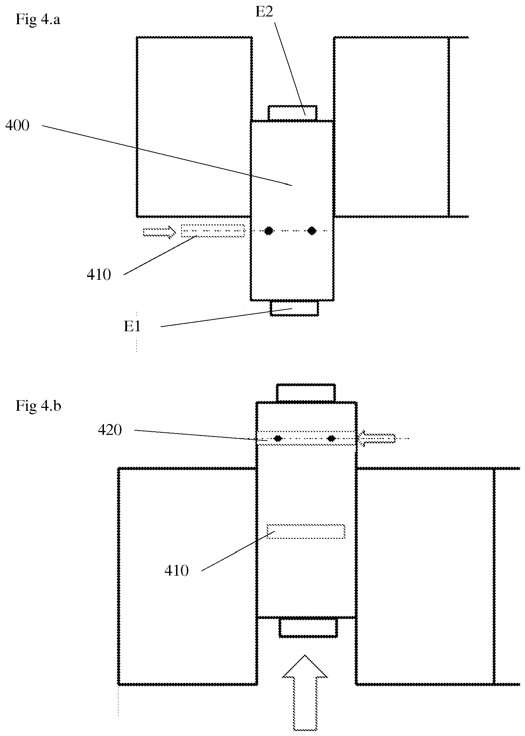

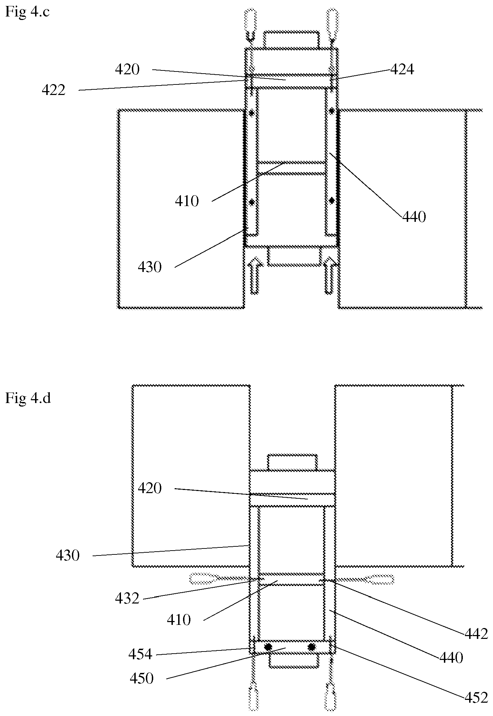

- La figure 4.a : une représentation schématique de la mise en place d'une première poutre ;
- La figure 4.b : une représentation schématique de la mise en place d'une deuxième poutre ;
- La figure 4.c : une représentation schématique de la mise en place d'une troisième poutre et d'une quatrième poutre ;
- La figure 4.d : une représentation schématique de la mise en place d'une cinquième poutre.

Pour plus de clarté, les éléments identiques ou similaires sont repérés par des signes de référence identiques sur l'ensemble des figures.

L'invention sera mieux comprise à la lecture de la description qui suit et à l'examen des figures qui l'accompagnent. Celles-ci sont présentées à titre indicatif et nullement limitatif de l'invention.

### DESCRIPTION DETAILLE D'UN MODE DE REALISATION

La figure 1.a montre une face 110 externe du plancher d'une armoire comportant un dispositif selon l'invention. La face est dite externe car elle est destinée à être positionnée face au sol. Le 110 plancher de l'armoire forme un quadrilatère rectangle.
La figure 1.a montre que la face 110 externe du plancher comporte deux ouvertures techniques permettant le passage de câbles et d'autres moyen, par exemple des tuyaux permettant la circulation de fluide caloporteur.

Une première ouverture 120 technique est située à proximité de l'arrière de l'armoire. Une deuxième ouverture 130 technique est située à proximité du centre du plancher de l'armoire.
La figure 1.a montre que, dans cette variante la face 110 externe comporte dix pions. Les pions sont disposés par paires définissant ainsi cinq droites qui correspondent à des positions de poutres d'un dispositif de répartition de charge selon l'invention. Ces cinq droites sont définies en fonction d'ouvertures techniques dans le plancher 110 de l'armoire, de manière à ce qu'elles ne traversent pas ces ouvertures. Chacune de ces cinq droites est parallèle à au moins l'un des côtés du quadrilatère formé par le plancher de l'armoire.
Dans la variante de l'invention représentée, quatre des cinq droites, la première droite D1, la deuxième droite D2, la troisième droite D3 et la quatrième droite D4 sont situées au bord du plancher de l'armoire en respectant les contraintes suivantes :
- La distance entre le bord du plancher de l'armoire et la droite correspond à une demi-largeur d'une poutre d'un dispositif de répartition de charge selon l'invention. Ainsi une fois la poutre en place elle n'augmente pas la surface au sol de l'armoire.
- Les droites ne traversent pas d'ouvertures techniques.
Ainsi en application de ces contraintes la quatrième droite D4 passe entre les première et deuxième ouvertures techniques.
La cinquième droite D5 est parallèle à la quatrième droite D4 et situé de l'autre côté de la deuxième ouverture technique relativement à la quatrième droite D4. Idéalement cette cinquième droite D5 est située au plus proche de la verticale d'un centre de masse de l'armoire, l'armoire étant considérée pleine. Une armoire pleine est une armoire dans laquelle ont été installés tous les équipements informatique qu'elle doit accueillir.
La figure 1.b montre une vue latérale extérieure de l'armoire en particulier au niveau de son plancher. En particulier la figure 1.b illustre qu'un pion comporte :
- Une tige T1 fixé au plancher de l'armoire,
- Une tête TT1 solidaire de la tige T1 à l'extrémité de la tige T1 opposée à celle fixée au plancher de l'armoire.
Le diamètre de la tête TT1 est supérieur au diamètre de la tige T1.
Tous les pions sont identiques par leur structure.

La figure 2.a montre une vue en coupe transversale d'une poutre 200 principale utilisée dans un dispositif de répartition de charge selon l'invention.

La figure 2.a montre que la section de la poutre est rectangulaire. Dans l'exemple de réalisation illustré la poutre a une hauteur de H de 62mm pour une largeur l de 37mm. Les deux parois latérales et la paroi inférieure ont une épaisseur e de 3mm.

La figure 2.a montre que la poutre comporte une structure interne formant un croisillon à quatre branches, chaque branche s'étendant depuis un coin intérieur de la poutre vers une poutre 210 interne de même proportion hauteur par largeur que la poutre elle-même. Les croisillons ont une épaisseur ec de 4mm. La poutre interne a une hauteur de 18mm.

La figure 2.a montre qu'une face 203 supérieure de la poutre comporte une fente 209 d'une largeur de 6.5mm. La distance df1 entre un côté de la poutre et un premier bord de la fente est de 15.25mm. La distance df2 entre ledit côté de la poutre et un deuxième bord de la fente est de 21.75mm. La face opposée à la face 203 supérieure est la face 206 inférieure. Les faces supérieure et inférieure sont parallèles.

La figure 2.a montre que les deux croisillons supérieurs de la structure interne de la poutre forment entre eux un angle as de 60°.

La figure 2.a montre que la poutre 210 interne comporte, au moins à proximité d'un bord de la poutre principale un taraudage 220 dont l'axe à la direction dans laquelle s'étend la poutre principale. Il s'agit de la direction selon laquelle on mesure la longueur de la poutre principale. Dans le mode de réalisation représenté le taraudage 220 a un diamètre de 6.8mm.

Ainsi configurée, la fente et les pions forment un système de suspension sur le principe de celui connu sous le nom de rainure en T.

La figure 2.b montre une vue en coupe transversale de la poutre 200 au niveau d'un orifice latéral. Pour la poutre principale un orifice latéral comporte en fait trois orifices coaxiaux :
- Un premier orifice 230 dans une première paroi latérale de la poutre principale ;
- Un deuxième orifice 240 dans la poutre centrale ;
- Un troisième orifice 250 dans une deuxième paroi latérale de la poutre principal ayant un diamètre identique à celui du premier orifice.

Le diamètre du deuxième orifice est tel qu'il permet le passage d'une vis d'assemblage destiné à être vissé dans le taraudage 220, c'est-à-dire un diamètre au moins égale, dans l'exemple décrit, à 6.8mm. Ce diamètre est inférieur au diamètre de la tête d'une telle vis d'assemblage.

Le diamètre du premier orifice est tel qu'il permet le passage de la tête de la vis d'assemblage cité au paragraphe précédent.

Dans une variante de l'invention un orifice latéral est circulaire. Dans une autre variante un orifice latéral est oblong pour permettre un ajustement des positions des poutres.

La figure 2.c montre une poutre utilisée dans un dispositif de répartition de charge selon l'invention. La figure 2.c montre que les entrées de la fente 209 peuvent être biseautées, c'est-à-dire plus large que la fente elle-même, pour faciliter la mise en place de la poutre.

La figure 3 montre la face 110 externe du plancher de l'armoire. La figure 3 montre une poutre 310 suspendue à un pion P1 de la face 110 externe.

La figure 3 montre également que la face 110 externe comporte au moins une roulette 320. Une telle roulette permet de déplacer l'armoire en la faisant rouler sur le sol.

La figure 3 illustre que lorsque que le dispositif de répartition de charge selon l'invention est en place, la roulette n'est plus en contact avec le sol ce qui signifie que :
- L'armoire ne peut plus être déplacée en roulant ;
- La roulette ne supporte plus le poids de l'armoire.

La figure 4.a montre une étape de mise en place d'une première poutre 410 pour la mise en place d'un dispositif de répartition de charge selon l'invention sur une armoire 400. La mise en place du dispositif de répartition de charge selon l'invention se fait une fois que l'armoire a été décollée du sol, c'est-à-dire une fois que ses roulettes ne sont plus en contact avec le sol. Cela est réalisé, par exemple, en utilisant des élévateurs : un premier élévateur E1 accroché à une face avant de l'armoire 400, un deuxième élévateur est accroché à une face arrière de l'armoire 400. Les deux élévateurs agissent ensemble. Le fait que les élévateurs soient accrochées aux faces avant et arrière laisse libre l'accès à la face externe du plancher de l'armoire. La première poutre est une poutre médiane installée dans une zone centrale du plancher de l'armoire. Cette poutre est installée en utilisant les pions formant la cinquième droite.
La longueur de la première poutre est égale à la largeur de l'armoire 400 moins 2 largeurs de poutre.
La figure 4.b montre qu'une fois la première poutre en place on déplace l'armoire de manière à rendre les pions matérialisant la quatrième droite accessible par les côtés de l'armoire. Une fois ce déplacement effectué on positionne une deuxième poutre 420 en utilisant les pions matérialisant la quatrième droite.
La deuxième poutre a une longueur égale à la largeur de l'armoire.
La figure 4.c montre la mise en place d'une troisième poutre 430 en utilisant les pions matérialisant la première droite.
La figure 4.c montre la mise en place d'une quatrième poutre 440 en utilisant les pions matérialisant la deuxième droite.
Les troisième et quatrième poutres ont des longueurs identiques et telles que lorsqu'elles sont en butées contre la deuxième poutre il reste une largeur de poutre entre l'avant de l'armoire et l'extrémité la plus proche des troisième et quatrième poutres.
La figure 4.c montre également qu'une fois les troisième et quatrième poutres en place on utilise deux vis d'assemblages :
- Une première vis 422 d'assemblage pour solidariser la deuxième poutre avec la troisième poutre en utilisant un taraudage de la troisième poutre et un premier orifice latérale de la deuxième poutre ;
- Une deuxième vis 424 d'assemblage pour solidariser la deuxième poutre avec la quatrième poutre en utilisant un taraudage de la quatrième poutre et un deuxième orifice latérale de la deuxième poutre.
La figure 4.d montre que l'on déplace l'armoire de manière à ce que les pions matérialisant la troisième droite et des taraudages de la première poutre soient accessibles.
La figure 4.d montre la mise en place d'une cinquième poutre 450 en utilisant les pions matérialisant la troisième droite
La cinquième poutre a une longueur identique à celle de la deuxième poutre.
La figure 4.d montre également qu'une fois la cinquième poutre en place on utilise quatre vis d'assemblages :
- Une troisième vis (442) d'assemblage pour solidariser la quatrième poutre avec la première poutre en utilisant un taraudage de la première poutre et un orifice latérale de la quatrième poutre;
- Une quatrième vis (452) d'assemblage pour solidariser la cinquième poutre avec la quatrième poutre en utilisant un taraudage de la quatrième poutre et un premier orifice latérale de la cinquième poutre ;
- Une cinquième vis (454) d'assemblage pour solidariser la cinquième poutre avec la troisième poutre en utilisant un taraudage de la troisième poutre et un deuxième orifice latérale de la cinquième poutre ;
- Une sixième vis (432) d'assemblage pour solidariser la troisième poutre avec la première poutre en utilisant un taraudage de la première poutre et un orifice latérale de la troisième poutre.
Une fois les vis d'assemblage en place on obtient une structure à 5 poutres rigide et fixée à l'armoire.
Pour les figures de la série 4 on n'a représenté que les éléments utiles pour la compréhension du procédé de mise en place du dispositif selon l'invention. Ainsi d'une figure à l'autre des pions et/ou vis d'assemblage peuvent disparaître sans que cela signifie quoique ce soit les concernant.
On peut alors placer l'armoire à sa place définitive et retirer les dispositifs de levage. L'armoire repose alors sur ce dispositif rigide sur lequel son poids se répartit. Le dispositif selon l'invention peut être mis en place au plus près de la place définitive de l'armoire et même dans une salle encombrée.
On note que le recours aux vis d'assemblage est facultatif. L'invention, c'est-à-dire la répartition de charge, est effective sans les vis. Ces dernières permettent de rigidifier la structure et de rendre le transport d'armoire équipée plus facile. On note également qu'une vis d'assemblage peut suffire, par exemple la quatrième ou la cinquième pour garantir l'inamovibilité de la structure de répartition de charge.
On note encore que la présence de taraudage peut permettre de solidariser entre eux des systèmes de répartition de charge en utilisant une pièce comportant deux orifices chacun des orifices correspondant à un orifice latéral d'une poutre de deux dispositifs de répartition de charge voisin.

L'intérêt de ce dispositif de répartition de charge pour les armoires informatiques en comparaison au système de liaison au sol classique avec des vérins a été démontré par des simulations mécaniques :
- Dans un cas de modélisation de faux-plancher, les déplacements sur les dalles du faux plancher ainsi que les contraintes locales ont été fortement diminuées. Cela permet de limiter la classe de faux plancher nécessaire à supporter les systèmes ou d'éventuels renforcements nécessaires pour soutenir les dalles aux endroits sollicités ;
- Dans une moindre mesure, les charges des armoires informatiques sont un peu mieux réparties sur les pieds du faux-plancher.

## Revendications

1. Dispositif de répartition de charge au sol pour une armoire informatique comportant un plancher dont une face externe est destinée à être positionnée face au sol **caractérisé en ce que** :
- la face (110) externe du plancher de l'armoire comporte une pluralité de pions chaque pion (P1) comportant à son extrémité la plus éloignée du plancher une tête (TT1) dont le diamètre est supérieur au diamètre d'une tige (T1) du pion, ladite tige assurant la liaison entre l'armoire et le pion,
- le dispositif de répartition de charge comporte au moins deux poutres, chaque poutre (200) comportant au moins deux faces planes parallèles :
- une première face (203) comporte une fente (209) servant de rail, la largeur de la fente étant supérieur au diamètre d'une tige de pion mais inférieure au diamètre d'une tête de pion, cette fente coopérant avec au moins deux pions pour la mise en place de la poutre,
- une deuxième face (206) est en contact avec le sol,
- une fois les poutres en place le poids de l'armoire est réparti sur les deuxièmes surfaces des poutres.

2. Dispositif de répartition de charge selon la revendication 1, **caractérisé en ce que** la structure interne d'une poutre est un croisillon.

3. Dispositif de répartition de charge selon l'une quelconque des revendications précédentes **caractérisé en ce que** :
- une première poutre comporte, intégré à sa structure interne, et à l'une des extrémités de la poutre un taraudage (220),
- une deuxième poutre comporte, sur les faces autres que celles en contact avec le sol ou l'armoire, un orifice (230, 240, 250) traversant pour le passage d'une vis d'assemblage permettant la solidarisation des première et deuxième poutres, la vis d'assemblage étant vissée dans le taraudage.

4. Dispositif de répartition de charge selon la revendication 3, **caractérisé en ce que** l'orifice traversant est oblong dans une direction correspondant à la plus grande dimension de la poutre.

5. Dispositif de répartition de charge selon l'une quelconque des revendications précédentes **caractérisé en ce que** la hauteur d'une poutre est telle qu'une fois la poutre en place des roulettes (320) de l'armoire ne sont plus en contact avec le sol.

6. Dispositif de répartition de charge selon l'une des revendications précédentes 3 à 5 **caractérisé en ce qu'**il comporte cinq poutres (410, 420, 430, 440, 450) :
- quatre d'entre elles formant un parallélépipède rectangle (420, 430, 440, 450) correspondant au périmètre du plancher de l'armoire,
- la cinquième (410) joignant deux bords parallèles du parallélépipède,
- des vis d'assemblages (422, 424, 442, 452, 454, 432) solidarisant les poutres formant le parallélépipède étant introduites via les faces des poutres correspondant aux faces avant et arrière de l'armoire.

## Patentansprüche

1. Lastverteilungsvorrichtung am Boden für einen Informatikschrank, umfassend einen Fußboden, dessen eine äußere Seite dazu bestimmt ist, mit der Seite zum Boden positioniert zu sein, **dadurch gekennzeichnet, dass**:
- die äußere Seite (110) des Bodens des Schranks eine Vielzahl von Klötzen umfasst, wobei jeder Klotz (P1) an seinem Ende, das vom Fußboden am weitesten entfernt ist, einen Kopf (TT1) umfasst, dessen Durchmesser größer ist als der Durchmesser eines Stiftes (T1) des Klotzes, wobei der genannte Stift die Verbindung zwischen dem Schrank und dem Klotz gewährleistet,
- die Lastverteilungsvorrichtung wenigstens zwei Balken umfasst, wobei jeder Balken (200) wenigstens zwei parallele, ebene Seiten umfasst:
∘ eine erste Seite (203) einen Schlitz (209) umfasst, der als Schiene dient, wobei die Breite des Schlitzes größer ist als der Durchmesser eines Klotzstiftes, jedoch kleiner ist als der Durchmesser eines Klotzstiftes, wobei dieser Stift mit wenigstens zwei Klötzen für das Einsetzen des Balkens zusammenwirkt,
∘ eine zweite Seite (206) mit dem Boden in Kontakt ist;
- sobald die Balken angeordnet sind, das Gewicht des Schranks auf den zweiten Oberflächen der Balken verteilt ist.

2. Lastverteilungsvorrichtung gemäß Anspruch 1, **dadurch gekennzeichnet, dass** die interne Struktur eines Balkens ein Doppelkreuz ist.

3. Lastverteilungsvorrichtung gemäß irgendeinem der voranstehenden Ansprüche, **dadurch gekennzeichnet, dass**:
- ein erster Balken in seiner internen Struktur integriert und an einem der Enden des Balkens ein Innengewinde (220) umfasst,
- ein zweiter Balken auf den Seiten, die nicht mit dem Boden oder dem Schrank in Kontakt sind, eine Öffnung (230, 240, 250) umfasst, die für den Durchgang einer Verbundschraube durchquert, die das feste Befestigen des ersten und zweiten Balkens zulässt, wobei die Verbundschraube in dem Innengewinde verschraubt ist.

4. Lastverteilungsvorrichtung gemäß Anspruch 3, **dadurch gekennzeichnet, dass** die durchquerende Öffnung in einer Richtung länglich ist, die der größten Abmessung des Balkens entspricht.

5. Lastverteilungsvorrichtung gemäß irgendeinem der voranstehenden Ansprüche, **dadurch gekennzeichnet, dass** die Höhe eines Balkens derart ist, dass die Rollen (320) des Schranks nicht mehr mit dem Boden in Kontakt sind, sobald der Balken angeordnet ist.

6. Lastverteilungsvorrichtung gemäß einem der voranstehenden Ansprüche 3 bis 5, **dadurch gekennzeichnet, dass** sie fünf Balken (410, 420, 430, 440, 450) umfasst:
- wobei vier von ihnen einen Quader (420, 430, 44, 450) formen, der dem Perimeter des Fußbodens des Schranks entspricht,
- der fünfte (410) zwei parallele Ränder des Quaders verbindet,
- Verbundschrauben (422, 424, 442, 452, 454, 432) die Balken fest miteinander verbinden, die den Quader formen und über die Seiten der Balken eingeführt sind, die den vorderen und hinteren Seiten des Schranks entsprechen.

## Claims

1. Device for spreading the floor-loading of a computer cabinet comprising a bottom of which an external face is intended to be positioned facing the floor **characterised in that**:
- an external face (110) of the bottom of the cabinet comprises a plurality of pins with each pin (P1) including at its end furthest from the bottom a head (TT1) the diameter of which is greater than the diameter of a shank (T1) of the pin, said shank providing the connection between the cabinet and the pin,
- the load-spreading device comprises at least two beams, with each beam (200) including at least two parallel flat faces:
∘ a first face (203) includes a slot (209) acting as a rail, with the width of the slot being greater than the diameter of a pin shank but less than the diameter of a pin head, with this slot cooperating with at least two pins for the installation of the beam,
∘ a second face (206) is in contact with the floor,
- once the beams are in place the weight of the cabinet is spread over the second surfaces of the beams.

2. Load-spreading device according to claim 1, **characterised in that** the internal structure of a beam is a crosspiece.

3. Load-spreading device according to any preceding claim **characterised in that**:
- a first beam comprises, integrated into its internal structure, and at one of the ends of the beam a tapping (220),
- a second beam comprises, on the faces other than those in contact with the floor or the cabinet, a through-orifice (230, 240, 250) for the passing of an assembly screw allowing for the fastening of the first and second beams, with the assembly screw being screwed into the tapping.

4. Load-spreading device according to claim 3, **characterised in that** the through-orifice is oblong in a direction corresponding to the largest dimension of the beam.

5. Load-spreading device according to any preceding claim **characterised in that** the height of a beam is such that once the beam is in place castor wheels (320) of the cabinet are no longer in contact with t floor.

6. Load-spreading device according to one of the preceding claims 3 to 5 **characterised in that** it comprises five beams (410, 420, 430, 440, 450) :
- four when they form a rectangle parallelepiped (420, 430, 440, 450) corresponding to the perimeter of the bottom of the cabinet,
- the fifth (410) joining two parallel edges of the parallelepiped,
- assembly screws (422, 424, 442, 452, 454, 432) fastening the beams that form the parallelepiped being introduced via the faces of the beams corresponding to the front and rear faces of the cabinet.
